Europäisches Patentamt

European Patent Office

Office européen des brevets

(11) Numéro de publication: **0 178 977**
**A1**

## (12) DEMANDE DE BREVET EUROPEEN

(21) Numéro de dépôt: 85401796.9

(22) Date de dépôt: 17.09.85

(51) Int. Cl.⁴: **H01L 23/48** , H01L 21/60

(30) Priorité: 21.09.84 FR 8414565

(43) Date de publication de la demande:
23.04.86 Bulletin 86/17

(84) Etats contractants désignés:
CH DE FR GB IT LI NL

(71) Demandeur: THOMSON-CSF
173, Boulevard Haussmann
F-75379 Paris Cedex 08(FR)

(72) Inventeur: Barre, Lucien
THOMSON-CSF SCPI 173, bld Haussmann
F-75379 Paris Cedex 08(FR)

(74) Mandataire: Guérin, Michel et al
THOMSON-CSF SCPI 19, avenue de Messine
F-75008 Paris(FR)

(54) Composant semiconducteur monté en boîtier plastique, et procédé de montage correspondant.

(57) L'invention concerne l'encapsulation d'un composant semiconducteur en boîtier plastique.

Le montage comprend une plaque de radiateur (52), une plaque de céramique (54), une contre-électrode de cuivre (56), une pastille semiconductrice (42); une broche de connexion (58) a son extrémité (60) repliée et soudée sur la contre-électrode (56); cette dernière est beaucoup plus grande que la pastille (42) et occupe presque toute la surface de la plaque de céramique. Les autres broches de connexion (62, 66) ont leur extrémité repliée au-dessus de zones métallisées de la surface supérieure de la pastille. Le montage se fait dans un positionneur usiné en cuvettes successives de dimensions décroissantes, pour réaliser un empilement soudé comprenant l'ensemble des éléments ci-dessus sauf les broches de connexion que l'on soude après sur l'empilement une fois qu'on a extrait celui-ci du positionneur.

FIG_3

Rank Xerox

EP 0 178 977 A1

# COMPOSANT SEMICONDUCTEUR MONTE EN BOITIER PLASTIQUE ET PROCEDE DE MONTAGE CORRESPONDANT

La présente invention concerne la fabrication de composants semiconducteurs discrets ou intégrés et plus particulièrement le montage de ces composants dans un boîtier de plastique.

L'invention s'intéresse à des assemblages en boîtier plastique pourvus d'une plaque métallique plane formant radiateur, et pourvus de broches de connexion sortant du boîtier, l'assemblage comprenant, à l'intérieur du boîtier, la superposition, sur la plaque formant radiateur, d'une plaque de céramique, d'une contre-électrode métallique, d'une pastille semiconductrice ayant une face arrière en contact électrique avec la contre-électrode et une face avant comportant au moins une zone métallisée, une des broches de connexion étant reliée électriquement à la contre-électrode et au moins une autre broche étant reliée électriquement à la zone métallisée de la face avant de la pastille.

Cette définition d'un type de montage est donnée globalement et n'exclut pas des variantes nombreuses, et notamment l'interposition d'autres plaques ou feuilles métalliques entre les éléments cités ci-dessus, par exemple une contre-électrode supplémentaire entre une zone métallisée de la face avant de la pastille semiconductrice et la broche de connexion à relier électriquement à cette zone.

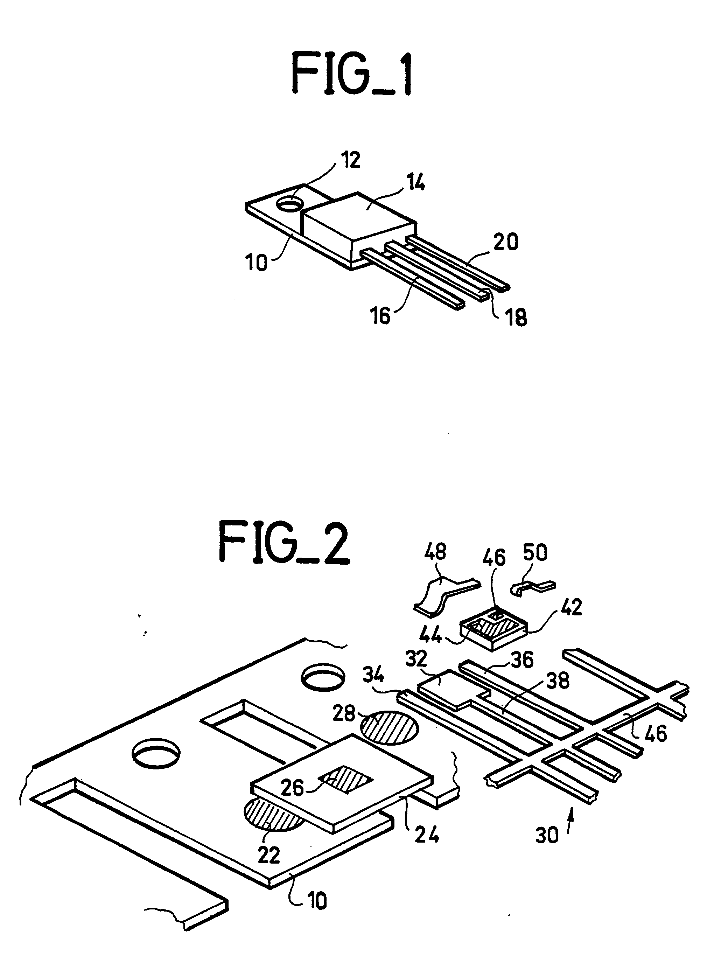

Un montage de ce type est celui qui est connu sous l'appellation "boîtier TO 220", dont l'aspect général est celui qui est visible à la figure 1 et qui sert usuellement au montage de transistors, thyristors ou triacs de moyenne puissance. Sur cette figure, on aperçoit la plaque métallique 10 formant radiateur, avec une ouverture circulaire 12 pour la fixation par vis sur un radiateur plus important, le boîtier plastique 14 enrobant les éléments du montage mais laissant dénudée une face arrière et une partie de la face avant de la plaque formant radiateur, et enfin les broches de connexion 16, 18, 20 au nombre de trois, sortant du boîtier essentiellement dans un plan parallèle au plan de la plaque 10.

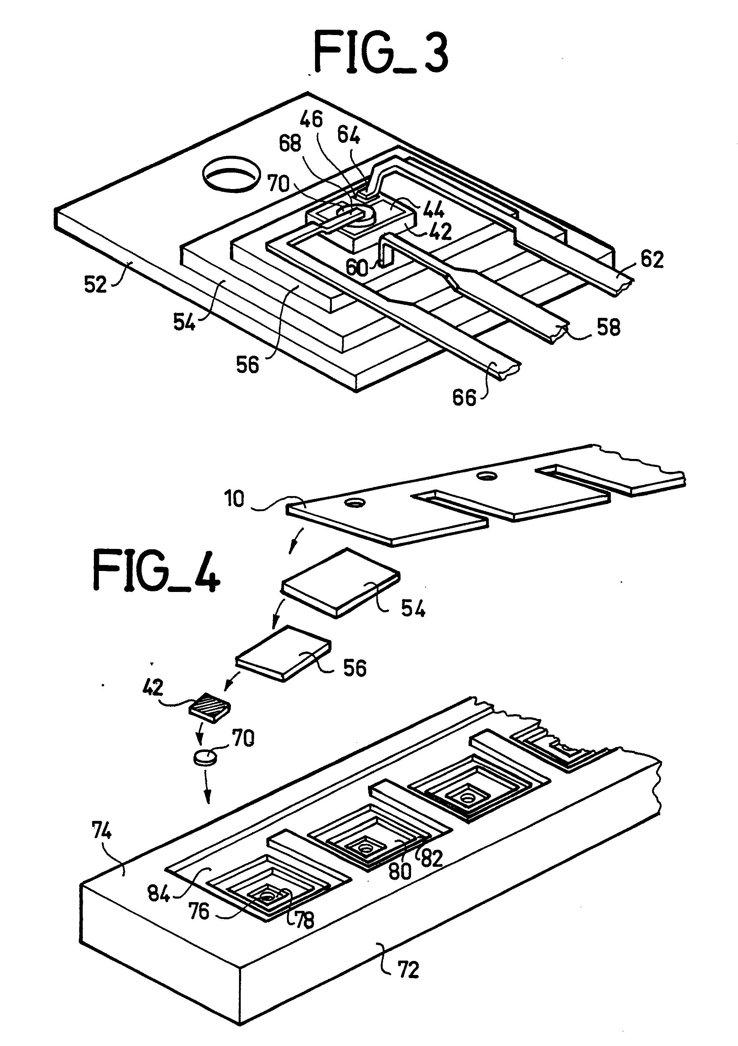

Ce type de montage est réalisé actuellement par la société demanderesse de la manière suivante (voir figure 2 qui montre les éléments avant assemblage): on part d'une plaque plane de radiateur 10 comportant des emplacements pour plusieurs composants; cette plaque sera ultérieurement découpée en composants individuels; on empile successivement sur la plaque 10, pour chaque composant, les éléments suivants: une feuille (préforme) de soudure 22; une plaque de céramique 24 nickelée en son centre 26, sur ses deux faces; une autre préforme de soudure 28; une grille de connexions 30 (lead-frame en anglais), qui est un ruban métallique découpé de manière à constituer à la fois une contre-électrode 32 et des broches de connexion 34, 36 et 38, la broche 38 servant de broche de connexion reliée à la contre-électrode 32; les broches de connexion sont solidarisées les unes des autres, et solidarisées d'ailleurs aussi des broches des autres composants montés simultanément sur la même plaque de radiateur, par un cadre 40 formant partie de la grille; ce cadre sera ultérieurement découpé pour individualiser les différentes broches; on place ensuite sur l'empilement la pastille semiconductrice 42 à encapsuler, en mettant sa face arrière métallisée revêtue de soudure au plomb en contact avec la contre-électrode 32; la face avant de la pastille comporte deux zones métallisées 44 et 46 visible sur la figure 2; par exemple une zone de contact de cathode et une zone de contact de gâchette pour un thyristor; ces zones sont également revêtues de soudure au plomb. Enfin, on met en place deux pontets conducteurs 48 et 50 conformés de manière à pouvoir contacter chacun à la fois une zone métallisée et une broche de connexion respective (34 et 36).

Pendant ce montage et jusqu'à la soudure des éléments ainsi empilés, le flux de la soudure présente entre les différentes pièces joue le rôle de colle pour maintenir en place ces pièces. On fait passer alors l'assemblage dans un four de soudure (vers 320°C), après quoi l'ensemble soudé est placé dans un moule et enrobé de résine thermodurcissable en laissant dénudée la face arrière de la plaque formant radiateur ; puis, les broches de connexion sont séparées les unes des autres par découpage et enfin la plaque de radiateur ellemême est découpée pour former des composants individuels.

En analysant de manière détaillée ce procédé de montage, on peut reconnaître l'existence de plusieurs inconvénients relatifs à la fois au procédé de montage luimême et au composant que ce procédé permet de réaliser.

Tout d'abord, l'empilement de la plupart des éléments se fait manuellement alors que leur positionnement est délicat; parfois, la grille de connexion est positionnée mécaniquement par rapport à la plaque de radiateur mais ce n'est pas le cas des autres pièces; en particulier, il serait très difficile d'envisager un positionnement automatique des pontets 48 et 50 entre les zones métallisées et les broches de connexion. Le rendement de fabrication est donc affecté par des défauts de positionnement.

Lorsque les éléments sont empilés, c'est le flux de la soudure qui joue le rôle de colle pour maintenir en place les éléments les uns par rapport aux autres jusqu'à la sortie du four de soudure. Le présence du flux est donc nécessaire, mais elle a l'inconvénient d'encrasser rapidement le four de soudure et les nacelles qui supportent les composants pendant leur passage dans le four. De plus, la présence de flux dans la soudure détériore la qualité de celle-ci car le flux forme dans la soudure des bulles nuisant à la qualité mécanique et à la conduction thermique de celles-ci en fonctionnement.

Il faut noter encore que le coût de fabrication des pontets conducteurs est élevé.

Enfin, la contre-électrode 32 formant partie intégrante de la grille de connexions a nécessairement une surface qui est essentiellement limitée à la surface de la pastille semiconductrice, ceci pour un ensemble de raisons tenant essentiellement au fait que cette contre-électrode est en pratique nécessairement limitée latéralement par les broches de connexion 34 et 36 qui l'encadrent. En effet ces broches 34 et 36 doivent s'approcher aussi près que possible des zones métallisées correspondantes de la pastille; il en résulte une limitation dans les possibilités de dissipation thermique, à travers la contre-électrode, la plaque de céramique et la plaque de radiateur, de la chaleur engendrée dans la pastille en fonctionnement.

Pour améliorer généralement les procédés de montage en boîtier et les qualités des composants semiconducteurs qui en résultent, la présente invention propose à la fois une nouvelle structure de composant semiconducteur encapsulé et un nouveau procédé de montage qui permet de réaliser cette structure.

Le composant semiconducteur selon l'invention est du type général indiqué ci-dessus, à savoir qu'il est monté dans un boîtier de matière plastique d'où sortent au moins deux broches de connexion, ce boîtier étant pourvu d'une plaque métallique plane formant radiateur, le montage intérieur au boîtier comprenant une superposition, sur la plaque formant radiateur, d'une plaque de céramique (électriquement isolante et thermiquement conductrice), d'une contre-électrode métallique, d'une pastille semiconductrice ayant une face arrière en contact électrique avec la contre-électrode et une face avant comportant au moins une zone métallisée, une des broches de connexion étant reliée électriquement à la contre-électrode et une autre à ladite zone métallisée.

Selon l'invention, on prévoit que :

a) la contre-électrode métallique a une surface beaucoup plus grande que la pastille semiconductrice,

b) la contre-électrode a des dimensions latérales légèrement plus petites que la plaque de céramique,

c) la broche de connexion reliée électriquement à la contre-électrode a une extrémité directement soudée sur la conte-électrode, dans une région de celle-ci non recouverte par la pastille,

d) les autres broches de connexion ont chacune une extrémité aboutissant au-dessus d'une zone métallisée respective de la pastille.

Dans une première variante d'exécution, les broches sont à section rectangulaire et issues du découpage d'une grille plane; dans une autre variante, elles sont constituées par des fils métalliques à section circulaire.

Le procédé de montage de composants sous boîtier plastique perfectionné selon l'invention est du type général consistant à d'abord former un empilement d'éléments soudés entre eux, parmi lesquels notamment une plaque métallique formant radiateur, une plaque de céramique, une contre-électrode métallique, une pastille semiconductrice ayant une face arrière métallisée et une face avant comportant au moins une zone métallisée et des broches de connexion électriques établissant en contact électrique d'une part avec la face arrière de la pastille par l'intermédiaire de la contre-électrode, d'autre part avec ladite zone métallisée de la face avant, puis à enrober de matière plastique l'empilement réalisé.

Selon l'invention, la réalisation de l'empilement soudé se fait de la manière suivante :

a) on place successivement, dans une pièce de métal formant positionneur, usinée en creux selon une configuration en cuvettes successives de dimensions latérales décroissantes de l'extérieur vers l'intérieur de la pièce, les éléments suivants ayant chacun des dimensions adaptées à celles de la cuvette dans laquelle ils sont placés:

- la pastille semiconductrice avec sa face avant tournée vers l'intérieur du positionneur,

- la contre-électrode,

- la plaque de céramique,

- la plaque formant radiateur et on prévoit entre les éléments adjacents un matériau de soudure adapté à la soudure de ces éléments adjacents entre eux.

b) on fait passer le positionneur ainsi rempli dans un four de soudure pour obtenir un assemblage rigide,

c) on extrait cet assemblage hors du positionneur,

d) on fixe sur l'assemblage des broches de connexion de manière à les relier électriquement d'une part à la contre-électrode, d'autre part auxdites zones métallisées de la face avant de la pastille.

D'autres caractéristiques et avantages de l'invention apparaîtront à la lecture de la description détaillée qui suit et qui est faite en référence aux dessins annexés dans lesquels:

- la figure 1 déjà décrite représente l'aspect extérieur d'un type de boîtier classique,

- la figure 2 également déjà décrite représente les éléments inclus dans le boîtier de la figure 1, avant leur assemblage, dans une fabrication selon un procédé utilisé par la demanderesse,

- la figure 3 représente, avant enrobage de plastique, un composant selon l'invention,

- la figure 4 illustre la première partie du procédé de fabrication selon l'invention,

-la figure 5 illustre la deuxième partie du procédé de fabrication selon l'invention,

- la figure 6 représente une variante d'exécution des broches de connexion.

On ne reviendra pas sur les figures 1 et 2 sinon pour mentionner que la présente invention permet d'aboutir à un composant qui, en fin de fabrication peut avoir l'apparence externe du composant de la figure 1.

Sur la figure 3, qui représente un mode de réalisation d'un composant encapsulé selon l'invention, on a désigné par 52 la plaque métallique formant radiateur, semblable à la plaque 10 de la figure 1; une plaque de céramique 54 est soudée sur la plaque de radiateur 52; elle sert à isoler électriquement le composant semiconducteur et ses connexions de la plaque de radiateur; elle a cependant une faible résistance thermique pour permettre l'évacuation aussi efficace que possible vers la plaque de radiateur de la chaleur dissipée par le composant; cette plaque correspond à la plaque 24 de la figure 2.

Une contre-électrode 56, par exemple en cuivre, est soudée sur la plaque de céramique. Fonctionnellement, elle correspond à la contre-électrode 32 de la figure 2 mais elle n'a pas la même constitution: d'une part elle occupe presque toute la surface de la plaque de céramique (ses dimensions latérales sont légèrement plus petites que celles de cette dernière); d'autre part, elle ne présente en principe pas d'extension s'étendant au-delà de la plaque de céramique comme l'extension constituée par la broche de connexion 38 à la figure 2. Ici, la contre-électrode 56 est simplement une plaque de cuivre rectangulaire.

La pastille semiconductrice à encapsuler est désignée par la même référence 42 qu'à la figure 2; elle ne présente pas de particularité par rapport à celles qui ont été mentionnées ci-dessus, et elle peut comporter par conséquent aussi sur sa face avant deux zones métallisées 44 et 46, sa face arrière étant également métallisée. La pastille est soudée par sa face arrière sur la contre-électrode 56.

Il est à noter que la surface de la pastille 42 est beaucoup plus faible que la surface de la contre-électrode 56. Cette dernière, qui est bonne conductrice thermique peut donc jouer un rôle de diffuseur de chaleur vers une large partie de la surface de la plaque de céramique et non vers une partie limitée à la surface de la pastille comme c'était le cas avec le montage de la figure 2. De plus, on peut choisir une épaisseur désirée pour la contre-électrode 56 sans être lié à l'épaisseur des broches de connexion ; en choisissant une épaisseur plus importante on améliore encore si on le désire la dissipation thermique.

Une première broche de connexion 58 est prévue pour réaliser un accès électrique à la face arrière de la pastille ; cette broche ne fait pas partie intégrante de la contre-électrode 56 mais son extrémité 60, éventuellement coudée par rapport à la direction générale de la broche, est soudée sur la surface de la contre- électrode à un endroit où celle-ci n'est pas recouverte par la pastille 42.

Dans l'exemple représenté à la figure 3, les broches de connexion sont planes et sont réalisées par matriçage d'une plaque de cuivre ou d'un autre matériau conducteur. Le repliement d'extrémité est réalisé pendant cette opération de matriçage de même que les repliements éventuels des autres broches.

Une deuxième broche de connexion 62 a été représentée ; elle sert à l'accès électrique vers la zone métallisée 46. Son extrémité repliée 64 aboutit au-dessus de cette zone 46 (contrairement à l'extrémité de la broche correspondante 36 de la figure 2 qui aboutissait à proximité de la pastille mais non au-dessus d'elle et encore moins au-dessus de la zone métallisée à accéder).

De même une troisième broche de connexion 66 sert à l'accès électrique vers la zone métallisée 44. Son extrémité repliée 68 aboutit au-dessus de cette zone.

Plusieurs variantes sont possibles pour la réalisation du contact électrique entre ces broches et les zones métallisées respectives. La figure 3 illustre ces deux variantes par une réalisation différente pour les broches 62 et 66, ces réalisations pouvant être utilisées indépendamment ou combinées comme à la figure 3. L'extrémité de la broche 62 est soudée directement sur la zone 46. L'extrémité de la broche 66 est soudée sur une contre-électrode supplémentaire 70 (en cuivre par exemple) elle-même soudée sur la zone métallisée 44.

On a ainsi décrit l'essentiel de la structure du montage en boîtier selon l'invention; bien entendu on peut prévoir l'interposition entre les éléments décrits d'autres éléments tels que par exemple une plaquette métallique interposée entre la contre-électrode 56 et la pastille, cette plaquette ayant un coefficient de dilatation adapté à celui du silicium. De telles adjonctions ne modifient pas la structure générale selon l'invention.

Dans l'exemple représenté à la figure 3, les broches de connexion sont planes (à section rectangulaire); elles pourraient être circulaires comme on le précisera à propos du procédé de fabrication, ce qui présente un avantage du point de vue de l'étanchéïté du boîtier de plastique à l'endroit de sortie des connexions; l'étanchéïté est bien meilleure autour de connexions circulaires.

On va maintenant décrire le procédé selon l'invention pour encapsuler un composant semiconducteur de manière à réaliser un composant final ayant l'aspect représenté à la figure 1.

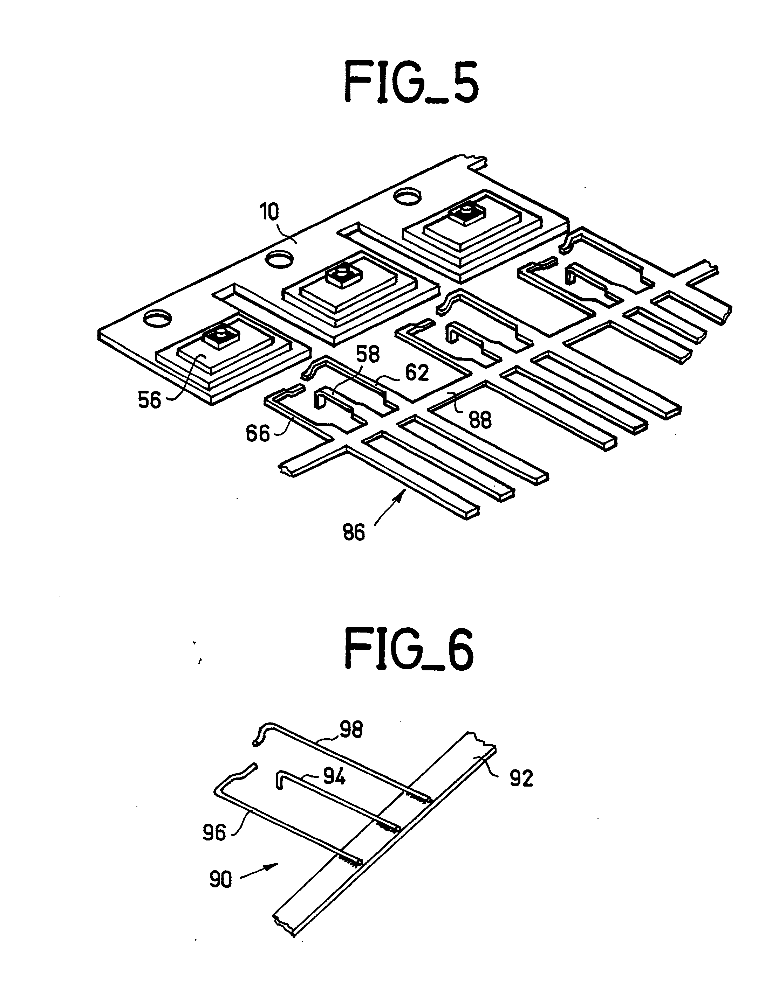

Le procédé comporte, avant l'enrobage dans la matière plastique, deux phases principales, la première phase étant expliquée en référence à la figure 4 et la deuxième phase à la figure 5.

La première phase consiste à réaliser un empilement d'éléments soudés les uns aux autres, tandis que la deuxième phase consiste à souder sur cet empilement des broches de connexion. Les phases suivantes sont classiques et ne seront pas décrites: enrobage par une résine thermodurcissable, séparation des broches de connexion, découpe en composants individuels si plusieurs composants sont formés simultanément sur une même plaque de radiateur.

Dans la première phase de fabrication, on utilise une pièce métallique 72 formant positionneur pour les différents éléments de l'assemblage empilé. Ce positionneur sert de préférence à réaliser simultanément, côte à côte, plusieurs assemblages de composants. Le métal utilisé est de préférence le même que celui qui constitue la plaque de radiateur 10 du composant, ou tout au moins on choisit un métal ayant le même coefficient de dilatation thermique.

Ce positionneur 72 est usiné très précisément (par un fraisage à commande numérique) et il comporte pour chaque composant à réaliser une succession de cuvettes ou alvéoles creusées à partir d'une surface supérieure 74 du positionneur.

Les cuvettes s'étagent successivement de la surface vers l'intérieur du positionneur. Elles ont des dimensions latérales décroissantes de la surface vers l'intérieur. Les dimensions de chaque cuvettes, y compris sa hauteur sont adaptées aux dimensions (y compris l'épaisseur) d'un élément respectif de l'assemblage.

Les éléments qui sont reçus dépendent du composant à réaliser. Pour réaliser le composant de la figure 3, on empilera les éléments qui ont été décrits à propos de cette figure, en notant que l'empilement se fera dans l'ordre contraire de celui qui se faisait dans les procédés de la technique antérieure (figure 2).

Les éléments à empiler sont représentés en vue éclatée à la figure 4 au-dessus du positionneur 74. Dans l'ordre on placera:

- la contre-électrode supplémentaire 70 dans une cuvette 76 (la plus petite et la plus profonde), si toutefois une telle contre-électrode doit être prévue. On peut envisager d'ailleurs plusieurs contre-électrodes dans des alvéoles différents au même niveau de profondeur dans la pièce 72,

- la pastille semiconductrice 42 dans une cuvette 78, avec sa face avant tournée vers l'intérieur de la pièce 72, la pastille étant orientée d'une manière appropriée compte tenu de la position de la cuvette 76 contenant la contre-électrode 70.

- la contre-électrode 56 dans une cuvette 80

- la plaque de céramique 54 dans une cuvette 82

- et la plaque de radiateur dans une cuvette 84.

En réalité la cuvette 84 sera conformée de manière à recevoir une plaque de radiateur 10 destinée à supporter plusieurs composants pour effectuer un montage de groupe comme on le faisait avec d'autres procédés.

En principe les cuvettes ont des dimensions latérales décroissantes de la surface vers l'intérieur de la pièce. Si par exception ce ne devait pas être le cas à cause par exemple de la présence d'un tenon en saillie (par exemple un tenon présent sur la contre-électrode 56, en saillie par rapport aux dimensions de la plaque de céramique 54), il faudrait bien entendu prévoir un élargissement local de certaines cuvettes (ouvertures pour laisser passer le tenon) de manière que les pièces de l'assemblage puissent être introduites dans le positionneur et que l'assemblage soudé puisse en être sorti.

Entre chacun des éléments à placer dans une cuvette respective, on prévoit un matériau de soudure appropriée, que ce soit un revêtement de soudure sur une pièce ou une feuille (préforme) de soudure interposée entre deux pièces. Les soudures utilisées peuvent être des pâtes, et elles n'ont pas besoin d'incorporer de flux.

Bien entendu d'autres pièces que celles qui ont été décrites cidessus peuvent être incorporées à l'empilement pourvu que la succession de cuvettes soit adaptée en conséquence.

Le positionneur 72 rempli des éléments, empilés dans les cuvettes correspondant à chaque composant à réaliser, est placé dans un four de soudure. Lorsqu'il en sort, l'empilement multiple est rigidifié et peut être extrait du positionneur.

Cet empilement subit alors la deuxième phase essentielle du procédé qui est une phase de soudure des broches de connexions.

On réalise alors un positionnement mécanique de la plaque de radiateur 10 portant l'empilement soudé, en regard d'une grille de connexions (lead-frame); cette grille est désignée par la référence 86 sur la figure 5; elle est réalisée par matriçage d'une feuille métallique. A la différence de la grille 30 de la figure 2, elle ne comporte, pour chaque composant, que des broches de connexions (ici trois broches 58, 62 et 66) reliées par un cadre de support 88, mais pas de contre-électrode telle que la contre-électrode 32 de la figure 2. De plus, les broches ont la conformation et la position correspondant à celle qui été définie à propos de la figure 3, c'est-à-dire que lorsque la grille de connexions est placée en regard de la plaque de radiateur 10, l'extrémité repliée 60 de la broche 58 vient au-dessus d'une partie découverte de la contre-électrode 56, l'extrémité repliée 64 de la broche 62 vient au-dessus d'une zone métallisée (46) à contacter sur la pastille, et l'extrémité repliée 68 de la broche 66 vient au-dessus d'une autre zone métallisée ou au-dessus de la contre-électrode supplémentaire 70 si celle-ci est prévue dans le montage.

Les broches sont alors soudées de la manière suivante :

- une soudure en pâte, en quantité optimum est déposée aux endroits précis où une liaison électrique doit intervenir (la tempé rature de fusion de cette soudure est inférieure à celle de l'opération précédente : par exemple 180 à 230°C).

Ces dépôts de pâte peuvent être effectués, par exemple par dispenseur automatique à commande numérique,

- la grille 86 est ensuite positionnée sur le sous-ensemble précédent.

- L'ensemble traverse un four à passage pour fusion de la pâte.

Le dispositif est alors prêt à être encapsulé de la même manière que dans les procédés actuellement exploités.

Dans une variante d'exécution, au lieu d'utiliser une grille de connexions 86 découpée dans une feuille métallique, on utilise un assemblage 90 de fils de connexion à section circulaire visible à la figure 6. Ces fils (94, 96, 98) sont fixés (soudés ou collés) sur un cadre ou une bande de support 92 et chacun des fils comporte une partie droite destinée à constituer la broche de connexion proprement dite sortant du boîtier, et une extrémité repliée selon la même conformation que les extrémités des broches de la grille découpée 86, de manière à venir au-dessus de la contre-électrode 56 et au-dessus des zones métallisées à contacter sur la pastille semiconductrice. Après soudure de ces fils sur l'assemblage empilé, et soit avant soit après enrobage dans la matière plastique, il ne reste qu'à couper ces fils pour les séparer de la bande support 92, en remarquant d'ailleurs que cette coupe se fait à l'autre extrémité des broches, donc loin du boîtier terminé.

## Revendications

1. Composant semiconducteur monté dans un boîtier de matière plastique (14) et pourvu d'un plaque métallique plane formant radiateur (10), au moins deux broches de connexion (16, 18 20 fig. 1 ; 58, 62, 66 fig. 3) sortant du boîtier, le montage comprenant à l'intérieur du boîtier une superposition, sur la plaque (10) formant radiateur, d'une plaque de céramique (54), d'une contre-électrode métallique (56), d'une pastille semiconductrice (42) ayant une face arrière en contact électrique avec la contre-électrode (56) et une face avant comportant au moins une zone métallisée (44, 46), une des broches de connexion (58) étant reliée électriquement à la contre-électrode (56) et au moins une autre (66, 62) étant reliée électriquement à ladite zone métallisée (44, 46) caractérisé en ce que :

a) la contre-électrode (56) a une surface beaucoup plus grande que la pastille semiconductrice (42),

b) la contre-électrode (56) a des dimensions latérales (longueur et largeur ou diamètre) légèrement plus petites que la plaque de céramique (54),

c) la broche de connexion (58) reliée électriquement à la contre-électrode (56) à une extrémité (60) directement soudée sur une partie de la contre-électrode non recouverte par la pastille semiconductrice,

d) les autres broches de connexions (62, 66) ont chacune une extrémité venant au-dessus d'une zone métallisée respective (46, 44) de la pastille.

2. Composant semiconducteur selon la revendication 1, caractérisé en ce qu'au moins une extrémité (68) de broche de connexion (66) est soudée sur une deuxième contre-électrode (70) elle-même soudée sur une zone métallisée (44) de la face avant de la pastille semiconductrice.

3. Composant semiconducteur selon la revendication 1, caractérisé en ce qu'au moins une extrémité (64) d'une broche de connexion (62) est soudée directement sur une zone métallisée (46) de la face avant de la pastille.

4. Composant semiconducteur selon la revendication 1, caractérisé en ce que les broches de connexion sont des fils conducteurs à section circulaire (94, 96, 98).

5. Procédé de montage sous boîtier plastique d'un composant semiconducteur, comprenant la formation d'un empilement d'éléments soudés entre eux parmi lesquels notamment une plaque métallique formant radiateur (10), une plaque de céramique (54), une contre-électrode métallique (56), et une pastille semiconductrice (42) ayant une face arrière métallisée et une face avant comportant au moins une zone métallisée, la mise en place de broches de connexion (58, 62, 66) établissant un contact électrique d'une part avec la face arrière de la pastille par l'intermédiaire de la contre-électrode (56), d'autre part avec ladite zone métallisée de la face avant de la pastille (42), et enfin l'enrobage de cet empilement par une matière plastique, caractérisé en ce que :

a) on place successivement, dans une pièce de métal (72) formant positionneur, usinée en creux selon une configuration en cuvettes successives (84, 82, 80, 78, 76) de dimensions latérales décroissantes de la surface vers l'intérieur de la pièce, les éléments suivants ayant chacun des dimensions adaptées à celles de la cuvette dans laquelle ils sont placés :

- la pastille semiconductrice (42) avec sa face avant tournée vers l'intérieur de positionneur (72),

- la contre-électrode métallique (56),

- la plaque de céramique (54),

- la plaque formant radiateur (10) et on prévoit entre chacun de ces éléments un matériau de soudure adapté à la soudure des éléments entre eux,

b) on fait passer le positionneur (72) ainsi rempli dans un four de soudure pour obtenir un assemblage rigide et parfaitement positionné des éléments,

c) on extrait cet assemblage hors du positionneur,

d) on fixe sur l'assemblage des broches de connexion (58, 60, 62) reliées électriquement d'une part à la contre-électrode d'autre part auxdites zones métallisées de la face avant de la pastille.

6. Procédé de montage selon la revendication 5, caractérisé en ce que l'extrémité d'une broche de connexion (58) est soudée directement sur la contre-électrode (56), sur une zone de celle-ci non recouverte par la pastille.

7. Procédé de montage selon l'une des revendications 5 et 6, caractérisé en ce que l'extrémité d'une broche de connexion (62) est soudée directement sur une zone métallisée de la face avant de la pastille.

8. Procédé de montage selon la revendication 7, caractérisé en ce que la positionneur est usiné de manière à inclure une cuvette destinée à recevoir une deuxième contre-électrode (70) à souder sur une zone métallisée de la face avant de la pastille semiconductrice, en ce que la mise en place des divers éléments dans le positionneur (72) comporte la mise en place de cette deuxième contre-électrode (70) avant la pastille, et enfin en ce que l'extrémité d'une broche de connexion (66) est soudée sur cette deuxième contre-électrode (70).

9. Procédé de montage selon l'une des revendications 1 à 8, caractérisé en ce que le positionneur (72) comporte plusieurs groupes de cuvettes correspondant chacune au montage d'un composant individuel, les cuvettes (84) destinées à recevoir la plaque métallique (10) formant radiateur étant reliées les unes aux autres et la plaque formant radiateur étant constiuée par une pièce unique pour plusieurs composants, cette pièce étant destinée à être coupée après montage pour séparer les composants en éléments individuels.

10. Procédé de montage selon l'une des revendications 1 à 9, caractérisé en ce que les broches de connexion sont des fils à section circulaire (94, 96, 98).

# FIG_1

# FIG_2

# FIG_3

# FIG_4

# FIG_5

# FIG_6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-4 346 396 (WESTERN) <br> * Figures 3,5,6; colonne 2, ligne 59 - colonne 5, ligne 6 * | 1 | H 01 L 23/48 <br> H 01 L 21/60 |
| A | | 3,5,7, 9 | |
| | --- | | |
| Y | DE-A-2 811 933 (G.E.C.) <br> * Figure 1; page 6, lignes 9-18 * | 1 | |
| A | | 4,10 | |
| | --- | | |
| A | US-A-3 500 136 (FISCHER) <br> * Figures 8,9; colonne 2, lignes 43-45 * | 2,6 | |
| | --- | | DOMAINES TECHNIQUES RECHERCHES (Int. Cl.4) |
| A | US-A-4 270 138 (G.E.C.) <br> * Figures 4,8; colonne 5, ligne 67 - colonne 6, ligne 9 * | 4,9,10 | H 01 L |
| | --- | | |
| A | GB-A-1 173 443 (RADIO CORP.) | | |
| | --- | | |
| A | PATENTS ABSTRACTS OF JAPAN, vol. 7, no. 45 (E-160)[1190], Page 167 E 160, 23 février 1983 & JP - A - 57 197 845 (NIPPON DENSO K.K.) 04-12-1982 | | |
| | ---     -/- | | |

Le présent rapport de recherche a été établi pour toutes les revendications

| Lieu de la recherche <br> LA HAYE | Date d'achèvement de la recherche <br> 18-12-1985 | Examinateur <br> CAMPLING N.C.G. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

| | **DOCUMENTS CONSIDERES COMME PERTINENTS** | | Page    2 |
|---|---|---|---|

| Catégorie | Citation du document avec indication. en cas de besoin. des parties pertinentes | Revendication concernée | CLASSEMENT DE LA DEMANDE (Int. Cl.4) |
|---|---|---|---|
| A | US-A-4 451 972   (BATINOVICH) | | |
| | ----- | | |
| | | | **DOMAINES TECHNIQUES RECHERCHES (Int. Cl.4)** |

Le présent rapport de recherche a été établi pour toutes les revendications

| Lieu de la recherche | Date d'achèvement de la recherche | Examinateur |
|---|---|---|
| LA HAYE | 18-12-1985 | CAMPLING N.C.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille, document correspondant

OEB Form 1503 03 82